# EUROPÄISCHE PATENTSCHRIFT

(11) **EP 2 020 038 B1**
(45) Veröffentlichungstag und Bekanntmachung des Hinweises auf die Patenterteilung: **05.07.2017**
(21) Anmeldenummer: 07722446.7
(22) Anmeldetag: 18.05.2007
(51) Int. Cl.: H01L 33/50, H01L 33/56

(54) **OPTOELEKTRONISCHER HALBLEITERCHIP MIT DREI WELLENLÄNGENKONVERSIONSSTOFFEN SOWIE OPTOELEKTRONISCHES HALBLEITERBAUELEMENT MIT EINEM SOLCHEN HALBLEITERCHIP UND VERFAHREN ZUR HERSTELLUNG DES OPTOELEKTRONISCHEN HALBLEITERCHIPS**
OPTOELECTRONIC SEMICONDUCTOR CHIP COMPRISING THREE WAVELENGTH CONVERSION SUBSTANCES, AND OPTOELECTRONIC SEMICONDUCTOR COMPONENT COMPRISING SUCH A SEMICONDUCTOR CHIP, AND METHOD FOR PRODUCING THE OPTOELECTRONIC SEMICONDUCTOR CHIP
PUCE DE SEMI-CONDUCTEUR OPTOÉLECTRONIQUE MUNIE DE TROIS SUBSTANCES DE CONVERSION DE LONGUEUR D'ONDE, COMPOSANT SEMI-CONDUCTEUR OPTOÉLECTRONIQUE MUNI D'UNE TELLE PUCE ET PROCÉDÉ DE FABRICATION DE CETTE PUCE DE SEMI-CONDUCTEUR OPTOÉLECTRONIQUE

(30) Priorität: 23.05.2006 DE 102006024165
(43) Veröffentlichungstag der Anmeldung: 04.02.2009
(73) Patentinhaber: OSRAM Opto Semiconductors GmbH, 93055 Regensburg (DE)
(72) Erfinder: BERBEN, Dirk, 82024 Taufkirchen (DE); JERMANN, Frank, 86343 Königsbrunn (DE)
(74) Vertreter: Epping - Hermann - Fischer
(86) Internationale Anmeldenummer: PCT/DE2007/000898
(87) Internationale Veröffentlichungsnummer: WO 2007/134582

(56) Entgegenhaltungen:
- EP-A- 0 855 751
- EP-A- 1 566 848
- EP-A- 1 592 074
- WO-A-01/69692
- WO-A-2007/051499
- WO-A-2007/069148
- JP-A- 11 204 832
- JP-A- 2003 298 120
- US-B1- 7 045 375

## Beschreibung

Die Erfindung betrifft einen optoelektronischen Halbleiterchip mit drei Wellenlängenkonversionsstoffen, ein optoelektronisches Bauelement mit einem solchen Halbleiterchip und ein Verfahren zur Herstellung des optoelektronischen Halbleiterchips.

Optoelektronische Halbleiterchips mit Wellenlängenkonversionsstoffen sind beispielsweise in der Druckschrift WO 97/50132 beschrieben. In dieser Druckschrift wird vorgeschlagen, den Wellenlängenkonversionsstoff beispielsweise in Form einer ganzflächig ausgebildeten Schicht auf den strahlungsemittierenden Halbleiterkörper aufzubringen. Der Wellenlängenkonversionsstoff der Schicht wandelt einen Teil der vom Halbleiterkörper emittierten Strahlung in Strahlung anderer Wellenlängen um, so dass der Halbleiterchip mischfarbige Strahlung, beispielsweise sichtbares weißes Licht, aussendet. Weiterhin wird auch beschrieben, nicht nur einen Wellenlängenkonversionsstoff zu verwenden, sondern zwei Wellenlängenkonversionsstoffe, beispielsweise um den Farbort der vom Halbleiterchip emittierten Strahlung besser einstellen zu können.

Bei der Verwendung zweier oder mehrerer Wellenlängenkonversionsstoffe in Verbindung mit optoelektronischen Halbleiterkörpern kann jedoch gegenseitige Absorption auftreten. Emittiert der Halbleiterkörper beispielsweise Strahlung aus dem blauen Spektralbereich, die teilweise von einem ersten Wellenlängenkonversionsstoff in Strahlung aus dem roten Spektralbereich und von einem anderen, zweiten Wellenlängenkonversionsstoff teilweise in Strahlung aus dem grünen Spektralbereich umgewandelt wird, so kann die von dem zweiten Wellenlängenkonversionsstoff in Strahlung aus dem grünen Spektralbereich konvertierte Strahlung durch den zweiten rot emittierenden Wellenlängenkonversionsstoff absorbiert werden. Dies erhöht die inneren Verluste des optoelektronischen Halbleiterchips und verringert somit dessen Effizienz. Weiterhin ist die Absorption von elektromagnetischer Strahlung durch Wellenlängenkonversionsstoffe in der Regel wellenlängenselektiv, wodurch es bei dem oben beschriebenen Effekt im Allgemeinen zu einer unerwünschten Verschiebung des Emissionsspektrums des Halbleiterchips kommt.

Wird nur ein Wellenlängenkonversionsstoff verwendet, so kommt es in der Regel aufgrund der begrenzten Dosiergenauigkeit zu Dickeschwankungen der wellenlängenkonvertierenden Schicht. Abweichungen in der Dicke der wellenlängenkonvertierenden Schicht von wenigen Mikrometern ändern jedoch den Farbort der von dem optoelektronischen Halbleiterchip emittierten Strahlung bereits erheblich. Reproduzierbare Schichtdicken über die gesamte Chipfläche herzustellen, erfordert weiterhin einen hohen Fertigungsaufwand.

EP 1 566 848 A (LUMILEDS LIGHTING LLC [US]; 2005-08-24), EP 0 855 751 A (IBM [US]; 1998-07-29) und JP 2003 298120 A (IDEC IZUMI CORP; 2003-10-17) offenbaren strahlungsemittierende optoelektronische Halbleiterchips mit mehreren verschiedenen wellenlängenkonvertierenden Schichten auf unterschiedlichen Teilbereichen der strahlungsemittierenden Halbleiterchip-Oberfläche.

Eine Aufgabe der Erfindung ist es, einen optoelektronischen Halbleiterchip mit einer wellenlängenkonvertierenden Schicht anzugeben, dessen Farbort auf einfache Art und Weise reproduzierbar eingestellt werden kann. Weitere Aufgaben der Erfindung sind es, ein optoelektronisches Halbleiterbauelement mit einem solchen Halbleiterchip sowie ein Verfahren zur Herstellung des optoelektronischen Halbleiterchips anzugeben.

Ein optoelektronischer Halbleiterchip gemäß der vorliegenden Erfindung ist in Anspruch 1 definiert. Bevorzugt beträgt der Flächenanteil des ersten Teilbereiches zum Flächenanteil des zweiten Teilbereiches einen Wert zwischen 10:1 und 1:10, wobei die Grenzen eingeschlossen sind. Besonders bevorzugt weist der zweite Teilbereich der Vorderseite bezogen auf die gesamte Fläche der Vorderseite einen Wert von ca. 30% auf. Auf dem zweiten oder zumindest einem vom ersten Teilbereich verschiedenen dritten Teilbereich der Vorderseite des Halbleiterkörpers ist eine zweite wellenlängenkonvertierende Schicht mit einem zweiten Wellenlängenkonversionsstoff aufgebracht, der Strahlung des ersten Wellenlängenbereichs in Strahlung eines vom ersten und zweiten Wellenlängenbereich verschiedenen dritten Wellenlängenbereiches umwandelt. Bei dieser Ausführungsform sind zwei unterschiedliche Wellenlängenkonversionsstoffe, die Strahlung des ersten Wellenlängenbereichs, die von dem Halbleiterkörper erzeugt wird, jeweils in unterschiedliche Wellenlängenbereiche umwandelt, auf verschiedenen diskreten Teilbereichen der strahlungsemittierenden Vorderseite des Halbleiterkörpers angeordnet. Durch diese räumliche Trennung der beiden unterschiedlichen Wellenlängenkonversionsstoffe wird die Absorption konvertierter Strahlung durch den anderen Wellenlängenkonversionsstoff vorteilhafterweise deutlich verringert. Bei dieser Ausführungsform können der erste Teilbereich und der dritte Teilbereich direkt aneinandergrenzen, das heißt zumindest eine gemeinsame Grenzflächen aufweisen. Alternativ ist es auch möglich, dass zwischen dem ersten Teilbereich und dem dritten Teilbereich zumindest ein weiterer Teilbereich angeordnet sind, der frei von wellenlängenkonvertierenden Schichten ist.

Bei einer weiteren bevorzugten Ausführungsform des Halbleiterchips wandelt die erste wellenlängenkonvertierende Schicht die Strahlung aus dem ersten Wellenlängenbereich, die von dem Halbleiterkörper im ersten Teilbereich emittiert wird vollständig in Strahlung des zweiten Wellenlängenbereichs um (im Folgenden auch "gesättigte Beschichtung" genannt).

Für eine wellenlängenkonvertierende Schicht in Form einer gesättigten Beschichtung wird innerhalb der wellenlängenkonvertierenden Schicht ein Überschuss des Wellenlängenkonversionsstoffs eingestellt, der bevorzugt so dimensioniert ist, dass wellenlängenkonvertierende Schichten mit Dicken innerhalb oder gleich des durch die Fertigungstoleranz vorgegeben Bereiches immer eine gesättigte Beschichtung ausbilden.

Bevorzugt transmittiert eine gesättigte Beschichtung nicht mehr als 5%, besonders bevorzugt nicht mehr als 1%, der von dem Halbleiterkörper in dem Bereich der Vorderseite emittierten Strahlung, auf den die wellenlängenkonvertierende Schicht aufgebracht ist.

Hierbei sind Randbereiche der wellenlängenkonvertierenden Schicht nicht berücksichtig, die beispielsweise auf Grund von Fertigungstoleranzen eine geringere Dicke als die restliche wellenlängenkonvertierende Schicht aufweist und daher auch einen größeren Anteil der von dem Halbleiterkörper erzeugten Strahlung transmittiert. Die Breite solcher Randbereiche, in denen die Dicke der wellenlängenkonvertierenden Schicht von deren Dicke im Inneren abweicht, ist in der Regel kleiner oder gleich der Schichtdicke der wellenlängenkonvertierenden Schicht.

Da die Emission des Halbleiterkörpers in der Regel nicht gerichtet von der Vorderseite erfolgt, sondern die ausgesandte Strahlung unterschiedliche Winkel mit der Vorderseite einschließt, gibt es weiterhin an den Rändern der wellenlängenkonvertierenden Schicht Bereiche, in denen die von der Vorderseite in diesen Bereichen emittierte Strahlung die wellenlängenkonvertierende Schicht nicht in ihrer vollständigen Dicke durchläuft, sondern einen kürzeren Weg zurücklegt. Aus diesen Gründen können an den Rändern der wellenlängenkonvertierenden Schicht, die in Form einer gesättigten Beschichtung vorliegt, mehr unkonvertierte Strahlung durch die wellenlängenkonvertierende Schicht hindurchdringen als in Innenbereichen der wellenlängenkonvertierenden Schicht.

Ebenso kann Strahlung, die von Bereichen der Vorderseite des Halbleiterkörpers ausgesandt wird, die an die Bereiche angrenzen auf die die wellenlängenkonvertierende Schicht aufgebracht ist, Strahlung durch die Ränder der wellenlängenkonvertierenden Schicht hindurchdringen. Auch diese Strahlung kann dazu beitragen, dass Ränder der wellenlängenkonvertierenden Schicht eine andere Abstrahlcharakteristik als Innenbereiche der wellenlängenkonvertierenden Schicht aufweisen.

Die oben genannten Randeffekt werden vorliegend bei der Beschreibung von wellenlängenkonvertierenden Schichten und deren Ausgestaltungen, wie etwa einer gesättigten Beschichtung nicht weiter berücksichtigt.

Wird eine zweite wellenlängenkonvertierende Schicht verwendet, so ist bei einer Ausführungsform diese zweite wellenlängenkonvertierende Schicht ebenfalls so ausgebildet, dass Strahlung aus dem ersten Wellenlängenbereich, die von der Vorderseite des Halbleiterkörpers in dem Teilbereich emittiert wird, die von der zweiten wellenlängenkonvertierenden Schicht bedeckt sind, vollständig in Strahlung des dritten Wellenlängenbereichs umgewandelt wird. Es handelt sich also hierbei bevorzugt wiederum eine gesättigte Beschichtung.

Wird nur eine einzige wellenlängenkonvertierende Schicht in Form einer gesättigten Beschichtung verwendet, so kann der Farbort der von dem Halbleiterchip emittierten Strahlung über das Verhältnis von beschichtetem zu unbeschichteten Flächenanteil der Vorderseite des Halbleiterkörpers eingestellt werden. Werden mehrere, beispielsweise zwei, verschiedene wellenlängenkonvertierende Schichten in Form einer gesättigten Beschichtung auf diskreten Teilbereichen der strahlungsemittierenden Vorderseite des Halbleiterkörpers verwendet, so kann der Farbort der von dem optoelektronischen Halbleiterchip emittierten Strahlung über den Flächenanteil der unterschiedlichen wellenlängenkonvertierenden Schichten zueinander und im Verhältnis zum unbeschichteten Flächenanteil der Vorderseite eingestellt werden.

Bei dem erfindungsgemäßen optoelektronischen Halbleiterchip ist über der Vorderseite des Halbleiterkörpers direkt auf die erste und die zweite wellenlängenkonvertierende Schicht eine dritte wellenlängenkonvertierende Schicht mit einem dritten Wellenlängenkonversionsstoff aufgebracht, der Strahlung des ersten Wellenlängenbereichs in Strahlung eines vom ersten, gegebenenfalls zweiten und gegebenenfalls dritten Wellenlängenbereich verschiedenen vierten Wellenlängenbereich umwandelt. Diese dritte wellenlängenkonvertierende Schicht ist bei einer Ausführungsform ganzflächig über der Vorderseite des optoelektronischen Halbleiterchips angeordnet, direkt auf der ersten und zweiten wellenlängenkonvertierenden Schicht.

Bei anderen, nicht erfindungsgemäßen Anordnungen ist auch die dritte wellenlängenkonvertierende Schicht nur über zumindest einem Teilbereich der Vorderseite angeordnet. Hierbei kann es sich zum einen um den ersten, den zweiten oder den dritten Teilbereich handeln oder auch um Zwischenräume oder Schnittmengen dieser Teilbereiche.

Die erste, zweite oder dritte wellenlängenkonvertierende Schicht kann jeweils so ausgeführt sein, dass Partikel des jeweiligen Wellenlängenkonversionsstoffs in einem Bindemittel eingebettet sind. Das Bindemittel kann beispielsweise aus der Gruppe ausgewählt sein, die durch die folgenden Materialien gebildet wird: Thermoplastische Materialien, Polystyrol, Latex, transparente Gummisorten, Glas, Polycarbonat, Acrylat, Teflon, Silikate, Wasserglas, Polyvinyl, Silikonharz, Epoxidharz, PMMA oder Hybridmaterialien aus Silikonharzen, Epoxidharzen bzw. PMMA.

Alternativ ist es auch möglich, dass die jeweilige wellenlängenkonvertierende Schicht kein Bindemittel enthält, sondern im Wesentlichen nur den jeweiligen Wellenlängenkonversionsstoff aufweist.

Bei einer weiteren bevorzugten Ausführungsform ist zumindest eine der zweiten oder dritten wellenlängenkonvertierenden Schichten als Folie ausgebildet oder von einer Folie umfasst, in der der jeweilige Wellenlängenkonversionsstoff enthalten ist. Soll die jeweilige wellenlängenkonvertierende Schicht nur auf oder über zumindest einem Teilbereich der Vorderseite des Halbleiterkörpers aufgebracht sein, so kann diese Folie entweder nur auf dem jeweiligen Teilbereich der Vorderseite des Halbleiterkörpers aufgebracht oder in sich vorstrukturiert sein, derart, dass nur ein Teilbereich der Folie mit Wellenlängenkonversionsstoff versehen ist. Bei letzterer Ausführungsform können auch Folienstücke, die größer sind als der jeweils mit wellenlängenkonvertierender Schicht zu versehenden Teilbereich oder beispielsweise auch die gesamte Vorderseite des Halbleiterkörpers mit der Folie bedeckt werden, um nur einen Teilbereich über oder auf der Vorderseite des Halbleiterkörpers mit wellenlängenkonvertierender Schicht zu versehen.

Weiterhin ist es möglich, dass ein Stück Folie zwei unterschiedliche Wellenlängenkonversionsstoffe jeweils in unterschiedlichen diskreten Teilbereichen aufweist, derart, dass die erste wellenlängenkonvertierende Schicht in einem ersten Teilbereich und die zweite wellenlängenkonvertierende Schicht in einem zweiten Teilbereich der Folie angeordnet ist. Diese Ausführungsform bietet den Vorteil, dass die erste und die zweite wellenlängenkonvertierende Schicht mittels eines Prozessschrittes auf die Vorderseite des Halbleiterkörpers aufgebracht werden kann.

Die Dicke einer solchen Folie kann beispielsweise zwischen 10 µm und 100 µm betragen, wobei die Grenzen eingeschlossen sind.

Die Folie kann beispielsweise durch Aufkleben auf oder über der Vorderseite des Halbleiterkörpers befestigt sein.

Es sei an dieser Stelle darauf hingewiesen, dass die jeweilige wellenlängenkonvertierende Schicht nicht nur auf jeweils einem einzigen Teilbereich der Vorderseite des Halbleiterkörpers aufgebracht sein kann, sondern auch auf mehreren Teilbereichen.

Bei einer Ausführungsform ist der erste und/oder der dritte Teilbereich streifenförmig ausgebildet. Die erste wellenlängenkonvertierende Schicht kann beispielsweise als ein einziger Streifen auf der Vorderseite aufgebracht sein oder in mehreren, beispielsweise parallel zueinander verlaufenden Streifen.

Wird eine zweite wellenlängenkonvertierende Schicht verwendet, die ebenfalls auf streifenförmigen Teilbereichen der Vorderseite angeordnet ist, so können sich die ersten streifenförmigen Teilbereiche mit den dritten streifenförmigen Teilbereichen abwechseln, d. h. dass auf einen erster Teilbereich mit der ersten wellenlängenkonvertierende Schicht ein dritter Teilbereich mit der zweiten wellenlängenkonvertierende Schicht folgt, derart, dass sich immer abwechselnd entsprechend streifenförmige wellenlängenkonvertierende Schichten nebeneinander befinden. Hierbei können zweite streifenförmige Teilbereiche zwischen den ersten und dritten Teilbereichen frei von wellenlängenkonvertierenden Schichten sein, oder jeweils direkt benachbarte Teilbereiche können gemeinsame Grenzflächen ausbilden.

Bei einer weiteren Ausführungsform ist der erste und/oder der zweite Teilbereich rund, beispielsweise kreisförmig, elliptisch oder oval ausgebildet.

Teilbereichen, die rund ausgebildet sind, können gegenüber streifenförmigen Teilbereichen einfacher auf statistische Art und Weise auf der Vorderseite des Halbleiterkörpers angeordnet werden. Ein statistisches Muster, das beispielsweise runde Teilbereiche umfasst, trägt zu einer diffusen Abstrahlcharakteristik des Halbleiterchips bei. Ein regelmäßiges Muster, beispielsweise regelmäßig angeordnete streifenförmige Teilbereiche, aber auch regelmäßig angeordnete runde Teilbereiche, können auf die Abstrahlcharakteristik des Halbleiterchips wie eine diffraktive Optik wirken.

Der erste, gegebenenfalls zweite und/oder gegebenenfalls dritte Wellenlängenkonversionsstoff ist beispielsweise aus der Gruppe gewählt, die durch die folgenden Stoffe gebildet wird: mit Metallen der seltenen Erden dotierte Granate, mit Metallen der seltenen Erden dotierte Erdalkalisulfide, - selenide, -sulfoselenide, mit Metallen der seltenen Erden dotierte Thiogallate oder Thiometalle, mit Metallen der seltenen Erden dotierte Aluminate, bariumhaltige Aluminate, mit Metallen der seltenen Erden dotierte Orthosilikate, mit Metallen der seltenen Erden dotierte Chlorosilikate, mit Metallen der seltenen Erden dotierte Nitridosilikate, mit Metallen der seltenen Erden dotierte Oxynitride mit Metallen der seltenen Erden dotierte Aluminiumoxinitride und mit seltenen Erden dotierte Halophosphate.

Besonders bevorzugt ist als erster, zweiter oder dritter Wellenlängenkonversionsstoff ein Ce-dotierter YAG-Wellenlängenkonversionsstoff (YAG:Ce) verwendet.

Weiterhin kann der oben beschriebene Halbleiterchip von einem optoelektronischen Halbleiterbauelement umfasst sein, wobei dem Halbleiterchip in dessen vorgesehener Abstrahlrichtung ein Vergussmaterial mit einem vierten Wellenlängenkonversionsstoff nachgeordnet ist, der Strahlung des ersten Wellenlängenbereich in Strahlung eines ersten, gegebenenfalls zweiten, gegebenenfalls dritten und gegebenenfalls vierten Wellenlängenbereich verschiedenen fünften Wellenlängenbereich umwandelt. Der Halbleiterchip kann hierbei beispielsweise in einer Ausnehmung eines Bauelementgehäuses angeordnet sein, wobei das Vergussmaterial die Ausnehmung des Bauelementgehäuses ganz oder teilweise füllt.

Ein Verfahren zur Herstellung eines optoelektronischen Halbleiterchips gemäß der Erfindung ist in Anspruch 9 definiert. Bei dem Verfahren wird auf zumindest einen vom ersten Teilbereich verschiedenen dritten Teilbereich der Vorderseite eine zweite wellenlängenkonvertierende Schicht mit einem zweiten Wellenlängenkonversionsstoff aufgebracht, der Strahlung des ersten Wellenlängenbereichs in Strahlung eines vom ersten und zweiten Wellenlängenbereich verschiedenen dritten Wellenlängenbereich umwandelt.

Die erste und gegebenenfalls die zweite bzw. dritte wellenlängenkonvertierende Schicht können beispielsweise mittels eines Druckverfahrens, wie Siebdruck, Ink-Jet-Drucken, Hochdruck oder Tiefdruck aufgebracht werden. Siebruckverfahren weisen in der Regel ein Auflösungsvermögen von ca. 70 µm auf. Besonders bevorzugt werden daher mit dieser Drucktechnik Teilbereiche mit Abmessungen zwischen 10 µm und 1 mm erzielt. Diese Drucktechnik bietet den Vorteil, dass sie zum einen auf technisch einfache Weise, reproduzierbar und günstig durchgeführt werden kann.

Die erste und/oder gegebenenfalls die zweite und/oder gegebenenfalls die dritte wellenlängenkonvertierende Schicht kann weiterhin mittels eines lithographischen Verfahrens aufgebracht werden. Hierzu wird die strahlungsemittierende Vorderseite des Halbleiterkörpers zuerst mit einem Photolack beschichtet, der sich in der Regel mit einer Auflösung von kleiner oder gleich 100 nm strukturieren lässt. Die Photolackschicht wird mittels eines Belichtungsschrittes mit dem gewünschten Muster strukturiert und in einem darauf folgenden Schritt wird die Oberfläche mit der jeweiligen wellenlängenkonvertierenden Schicht bedeckt. Handelt es sich bei der wellenlängenkonvertierenden Schicht um eine Schicht mit einem Bindemittel, so wird der Wellenlängenkonversionsstoff in das Bindemittel eingebracht und diese Mischung in einer Schicht auf der Photolackschicht aufgebracht, beispielsweise durch Drehschleudern. Anschließend wird der verbliebene Photolack abgelöst, derart dass die wellenlängenkonvertierende Schicht das inverse Muster der Photolackschicht ausbildet. Mittels eines lithographischen Verfahrens können in der Regel sehr hohe Auflösungen, beispielsweise kleiner oder gleich 100 nm, erreicht werden.

Mittels eines Druckverfahrens können die wellenlängenkonvertierenden Schichten vorteilhafterweise in einem Verfahrensschritt auf strukturierte Art und Weise aufgebracht werden. Im Gegensatz zu lithographischen Methoden ist keine Photolackmaske notwendig. Lithographische Methoden bieten in der Regel jedoch gegenüber Druckverfahren eine höhere Auflösung.

Weiterhin kann die erste und/oder gegebenenfalls die zweite und/oder gegebenenfalls die dritte wellenlängenkonvertierende Schicht auch unter Verwendung eines elektrophoretischen Verfahrens aufgebracht werden. Hierzu wird der Halbleiterkörper teilweise mit einem isolierenden Lack, beispielsweise mit einem Photolack mittels des oben beschriebenen lithographischen Verfahrens beschichtet. Danach wird durch Einfluss eines elektrischen Felds Wellenlängenkonversionsstoff aus einer flüssigen Phase direkt auf der Vorderseite des Halbleiterkörpers in den nicht gelackten Teilbereichen abgeschieden. Auf diese Art und Weise kann eine wellenlängenkonvertierende Schicht ohne Bindemittel, erzeugt werden.

Weiterhin ist es auch möglich, anstelle der Photolackschicht auf die zu beschichteten Teilbereiche der Vorderseite eine leitfähige Beschichtung als Elektrode aufzubringen, auf der sich während der Elektrophorese der jeweilige Wellenlängenkonversionsstoff strukturiert anlagert. Diese leitfähige Beschichtung ist bevorzugt durchlässig für die von dem Halbleiterkörper emittierte Strahlung. Bei dieser leitfähigen Beschichtung kann es sich beispielsweise um eine Beschichtung handeln, die ein transparentes leitendes Oxid (TCO) aufweist oder aus einem solchen besteht. Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein.

Wie bereits weiter oben beschrieben, ist es weiterhin auch möglich, dass die zweite und/oder gegebenenfalls die dritte wellenlängenkonvertierende Schicht als Folie aufgebracht wird. Dies erfolgt bevorzugt durch Aufkleben. Dieses Verfahren bietet den Vorteil, dass es in der Regel besonders preisgünstig ist.

Das Folienmaterial kann beispielsweise aus der Gruppe ausgewählt sein, die durch die folgenden Materialien gebildet wird: Thermoplastische Materialien, Polystyrol, Latex, transparente Gummisorten, Polycarbonat, Acrylat, Teflon, Polyvinyl, Silikonharz, Epoxidharz, PMMA oder Hybridmaterialien aus Silikonharzen, Epoxidharzen bzw. PMMA.

Bevorzugt ist als Halbleiterkörper ein Dünnfilm-Halbleiterkörper verwendet.

Ein Dünnfilm-Halbleiterkörper zeichnet sich insbesondere durch mindestens eines der folgenden charakteristischen Merkmale aus:
- an einer zu einem Trägerelement hin gewandten ersten Hauptfläche einer strahlungserzeugenden Epitaxieschichtenfolge als Halbleiterschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;

- der Dünnfilmhalbleiterkörper umfasst ein Trägerelement, bei dem es sich nicht um das Wachstumssubstrat handelt, auf dem die Epitaxieschichtenfolge epitaktisch gewachsen wurde, sondern um ein separates Trägerelement, das nachträglich an der Epitaxieschichtenfolge befestigt wurde,
- das Wachstumssubstrat der Epitaxieschichtenfolge ist von der Epitaxieschichtenfolge entfernt oder derart gedünnt, dass es zusammen mit der Epitaxieschichtenfolge alleine nicht frei tragend ist, oder
- die Epitaxieschichtenfolge weist eine Dicke im Bereich von 20µm oder weniger, insbesondere im Bereich von 10 µm auf.

Das Trägerelement ist bevorzugt durchlässig für eine von dem Halbleiterchip emittierte Strahlung ausgebildet.

Weiterhin enthält die Epitaxieschichtenfolge bevorzugt mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnfilm-Halbleiterkörpers ist beispielsweise in I. Schnitzer et al., Appl. Phys. Lett. 63 (16), 18. Oktober 1993, 2174 - 2176 beschrieben. Ein Dünnfilm-Halbleiterkörper ist in guter Näherung ein Lambertscher Oberflächenstrahler und eignet sich daher insbesondere für die Anwendung in einem Scheinwerfer.

Die Verwendung eines Dünnfilm-Halbleiterkörpers bietet den Vorteil, dass dieser in der Regel eine plane strahlungsemittierende Vorderseite aufweist, die mit den oben beschriebenen Techniken, wie beispielsweise Siebdruck, einfach mit der/den wellenlängenkonvertierenden Schicht(en) versehen werden kann.

Im Folgenden wird die Erfindung anhand von verschiedenen Ausführungsbeispielen in Verbindung mit den Figuren 1A bis 6B näher erläutert.

Es zeigen:
Figuren 1A bis 1C, schematische Darstellungen des Halbleiterchips gemäß verschiedener Herstellungsschritte des erfindungsgemäßen Verfahrens,
Figur 1D, eine schematische Schnittansicht des Halbleiterchips der Figur 1C entlang der Linie AA',
Figur 1E, eine schematische Schnittansicht eines Halbleiterchips gemäß einem Ausführungsbeispiel,
Figur 2A, eine schematische Draufsicht auf einen Halbleiterchip,
Figur 2B, eine schematische Schnittdarstellung des Halbleiterchips der Figur 2A entlang der Linie BB',
Figur 3A, eine schematische Draufsicht auf einen Halbleiterchip,
Figur 3B, eine schematische Schnittdarstellung durch den Halbleiterchip der Figur 3A entlang der Linie CC',
Figur 4A, eine schematische Draufsicht auf einen Halbleiterchip,
Figur 4B eine schematische Schnittdarstellung des Halbleiterchips gemäß Figur 4A entlang der Linie DD',
Figur 5A, eine schematische Draufsicht auf einen Halbleiterchip,
Figur 5B, eine schematische Schnittdarstellung durch ein Bauelement mit dem Halbleiterchip gemäß der Figur 5A, und
Figuren 6A und 6B, tabellarische Auflistungen verschiedener Wellenlängenkonversionsstoffe.

In den Ausführungsbeispielen und Figuren sind gleiche oder gleich wirkende Bestandteile jeweils mit den gleichen Bezugszeichen versehen. Die dargestellten Elemente sind grundsätzlich nicht als maßstabsgerecht anzusehen, vielmehr können einzelne Elemente, wie beispielsweise Schichtdicken oder Strukturgrößen zum besseren Verständnis übertrieben groß dargestellt sein.

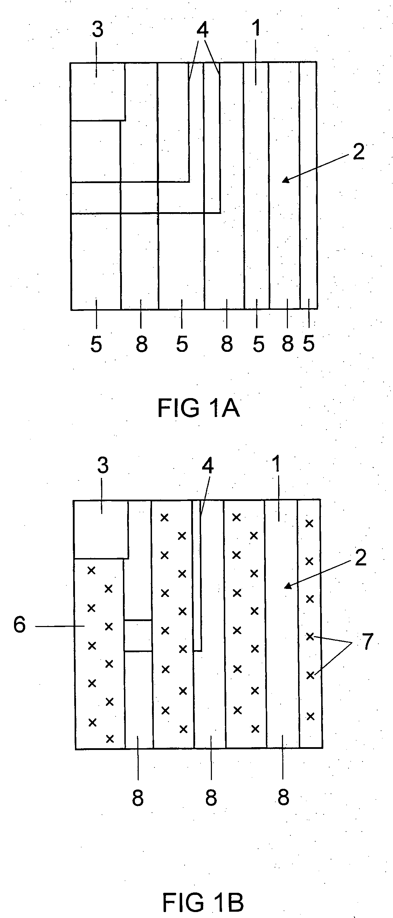

Der Halbleiterkörper 1 gemäß der Figur 1A weist auf seiner strahlungsemittierenden Vorderseite 2 ein Bondpad 3 zur späteren elektrischen Kontaktierung sowie Leiterbahnen 4 zur besseren Stromeinprägung in den Halbleiterkörper 1 auf. Bei dem Halbleiterkörper 1 kann es sich beispielsweise um einen Leuchtdiodenkörper, handeln.

Weiterhin weist der Halbleiterkörper 1 eine Halbleiterschichtenfolge mit einer aktiven strahlungserzeugenden Zone auf, die beispielsweise einen pn-Übergang, eine Doppelheterostruktur, eine Einfach-Quantentopfstruktur oder eine Mehrfach-Quantentopfstruktur zur Strahlungserzeugung umfasst. Die Halbleiterschichtenfolge kann beispielsweise epitaktisch gewachsen sein, etwa auf einem Wachstumssubstrat. Beispiele für Quantentopfstrukturen sind in den Druckschriften WO 01/39282, WO 98/31055, US 5,831,277, EP 1 017 113 und US 5, 684, 309 beschrieben. Der Halbleiterkörper 1 basiert beispielsweise auf einem III/V-Verbindungshalbleitermaterial, wie einem Arsenid-, einem Phosphid- oder einem Nitrid-Verbindungshalbleitermaterial, dass heißt, dass zumindest ein Schicht der Halbleiterschichtenfolge, bevorzugt die aktive Zone, ein Nitrid-, Phosphid- oder Arsenidverbindungshalbleitermaterial umfasst oder aus einem solchen besteht.

Nitrid-Verbindungshalbleitermaterialien sind Verbindungshalbleitermaterialien, die Stickstoff enthalten, wie beispielsweise Materialien aus dem System InₓAl_{y}Ga_{1-x-y}N mit 0 ≤ x ≤ 1, 0 ≤ y ≤ 1 und x+y ≤ 1. Phosphid-Verbindungshalbleitermaterialien sind Verbindungshalbleitermaterialien, die Phosphor enthalten, wie beispielsweise Materialien aus dem System InₓAl_{y}Ga_{1-x-y}P mit 0 ≤ x ≤ 1, 0 ≤ y ≤ 1 und x+y ≤ 1, während Arsenid-Verbindungshalbleitermaterialien Verbindungshalbleitermaterialien sind, die Arsen enthalten, wie beispielsweise Materialien aus dem System InₓAl_{y}Ga_{1-x-y}As mit 0 ≤ x ≤ 1, 0 ≤ y ≤ 1 und x+y ≤ 1.

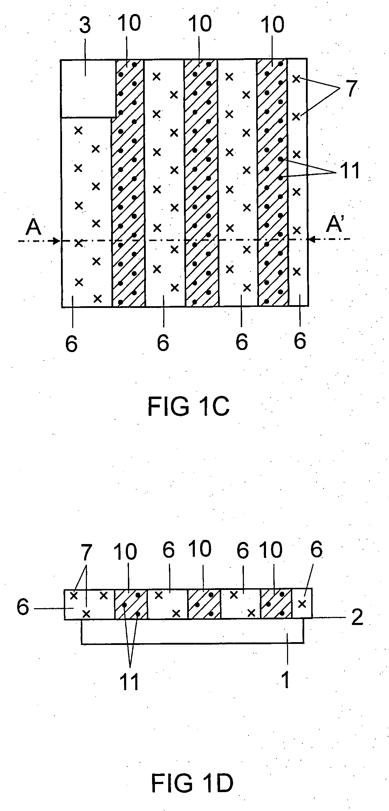

Um den Halbleiterchip 18 der Figuren 1C und 1D (nachfolgenden noch im Detail beschrieben) ausgehend von dem Halbleiterkörper 1 gemäß der Figur 1A herzustellen, wird auf erste Teilbereiche 5 einer strahlungsemittierenden Vorderseite 2 des Halbleiterkörpers 1 eine erste wellenlängenkonvertierende Schicht 6 mit einem ersten Wellenlängenkonversionsstoff 7 aufgebracht, wobei zweite Teilbereiche 8 der strahlungsemittierenden Vorderseite 2 frei von der ersten wellenlängenkonvertierenden Schicht 6 bleiben (siehe Figur 1B). Vorliegend weist die erste wellenlängenkonvertierende Schicht 6 neben Partikeln des ersten Wellenlängenkonversionsstoffs 7 ein Bindemittel, beispielsweise eines der im allgemeinen Beschreibungsteil bereits aufgeführten Materialien, auf. Weiterhin sind die ersten sowie zweiten Teilbereiche 5,8 der Vorderseite 2 des Halbleiterkörpers 1 bei dem vorliegenden Ausführungsbeispiel streifenförmig ausgebildet.

In einem weiteren Schritt wird in dritten Teilbereichen 9 der strahlungsemittierenden Vorderseite 2, die vorliegend mit den zweiten Teilbereichen 8 der strahlungsemittierenden Vorderseite 2 identisch sind, eine zweite wellenlängenkonvertierende Schicht 10 aufgebracht, die, wie die erste wellenlängenkonvertierende Schicht 6, neben Partikeln eines zweiten Wellenlängenkonversionsstoffes 11 ein Bindemittel enthält (Figuren 1C und 1D).

Das Aufbringen der wellenlängenkonvertierenden Schichten 6, 10 kann beispielsweise mit Hilfe eines Druckverfahrens, wie Siebdruck oder Ink-Jet-Drucken, erfolgen.

Mittels Siebdruck können beispielsweise Wellenlängenkonversionsstoff/Bindemittelsuspensionen als wellenlängenkonvertierende Schichten 6,10 aufgebracht werden, die Granate, Oxinitride oder Nitridosilikate als Wellenlängenkonversionsstoffe 7,11 mit einem Feststoffanteil zwischen 50 Vol% und 70 Vol% aufweisen. Die verwendeten Wellenlängenkonversionsstoffe 7,11 weisen bevorzugt einen d₅₀-Wert (Median) kleiner oder gleich 15 µm auf.

Alternativ kann eine der beiden wellenlängenkonvertierenden Schichten 6, 10, beispielsweise die erste wellenlängenkonvertierende Schicht 6, mittels einem lithographischen Verfahren auf die strahlungsemittierende Vorderseite 2 des Halbleiterkörpers 1 aufgebracht werden. Hierzu wird auf die Vorderseite 2 des Halbleiterkörpers 1 eine Photolackschicht aufgebracht, die mittels eines Belichtungsschrittes in erste und zweite Teilbereiche 5,8 unterteilt wird. Mit Hilfe eines Entwicklungsschrittes wird der Photolack auf den ersten Teilbereichen 5 der Vorderseite 2 des Halbleiterkörpers 1 abgelöst, derart, dass zweite Teilbereiche 8 der Vorderseite 2 frei von der Photolackschicht sind. In einem weiteren Schritt wird die erste wellenlängenkonvertierende Schicht 6 ganzflächig auf die vorstrukturierte Vorderseite 2 des Halbleiterkörpers 1 aufgebracht und der Photolack abgelöst. Durch das Entfernen des Photolackes in den zweiten Teilbereichen 8 der Vorderseite 2 wird hier ebenfalls die darüber liegende erste wellenlängenkonvertierende Schicht 6 entfernt, derart, dass die erste wellenlängenkonvertierende Schicht 6 nur in den ersten Teilbereichen 5 der Vorderseite 2 ausgebildet ist und die zweiten Teilbereiche 8 der Vorderseite 2 frei von der ersten wellenlängenkonvertierenden Schicht 6 sind.

Umfasst die erste wellenlängenkonvertierende Schicht 6, wie oben erwähnt, neben Partikeln des ersten Wellenlängenkonversionsstoffes 7 weiterhin ein Bindemittel, so kann die Bindemittel-Wellenlängenkonversionsstoffmischung beispielsweise auf die vorstruktrierte Photolackschicht mittels eines Drehschleuderverfahrens (Spin-Coating), Rakeln oder mittels Sprayen aufgebracht werden.

Soll eine wellenlängenkonvertierende Schicht 6,10 aufgebracht werden, die im Wesentlichen nur aus Partikeln des jeweiligen Wellenlängenkonversionsstoffes 7, 11 besteht, so kann diese beispielsweise auf eine leitende Elektrode auf der Vorderseite 2 des Halbleiterkörpers 1 aufgebracht werden, die durchlässig für die von dem Halbleiterkörper 1 emittierte Strahlung ist. Die Elektrode ist hierbei auf den Teilbereichen der Vorderseite aufgebracht, die mit der wellenlängenkonvertierenden Schicht bedeckt werden sollen. Bei der Elektrode kann es sich beispielsweise um eine TCO-Beschichtung handeln, wie sie bereits im allgemeinen Beschreibungsteil beschrieben wurde. Anschließen wird der mit der Elektrode vorstrukturierte Halbleiterkörper 1 in eine Suspension eingebracht, die den Wellenlängenkonversionsstoff der aufzubringenden wellenlängenkonvertierenden Schicht aufweist und eine elektrische Spannung, beispielsweise zwischen 50 V und 200 V angelegt, derart, dass sich die Partikel des Wellenlängenkonversionsstoffes an der Vorderseite 2 des Halbleiterkörpers 1 anlagern. Erfindungsgemäß ist vorgesehen, mindestens eine der beiden wellenlängenkonvertierenden Schichten 6, 10 als Folie auf die strahlungsemittierende Vorderseite 2 des Halbleiterkörpers 1 aufzubringen, beispielsweise mittels Kleben. Hierbei können entweder Folienstücke, die die Abmessungen der einzelnen zu beschichteten Teilbereiche aufweisen auf den jeweiligen Teilbereichen angeordnet werden, oder es kann eine vorstrukturierte Folie, die nur in ersten Teilbereichen 5 den ersten Wellenlängenkonversionsstoff 7 aufweist, auf die Vorderseite 2, beispielsweise flächendeckend, aufgebracht werden. Sollen zwei verschiedene wellenlängenkonvertierende Schichten 6, 10 auf erste und dritte Teilbereiche 5, 9 aufgebracht werden, kann beispielsweise eine vorstrukturierte Folie verwendet werden, die einen ersten Wellenlängenkonversionsstoff 7 in ersten Teilbereichen 5 und einen zweiten Wellenlängenkonversionsstoff 11 in dritten Teilbereichen 9 aufweist.

Eine solche vorstrukturierte Folie kann beispielsweise folgendermaßen hergestellt werden: Auf einer Arbeitsoberfläche, beispielsweise aus Teflon, wird, etwa mittels eines Druckverfahrens, der jeweils gewünschte Wellenlängenkonversionsstoff strukturiert aufgebracht. In einem weiteren Schritt wird das Folienmaterial aufgegossen und in einem dritten Schritt vernetzt. Bei dem Folienmaterial kann es sich beispielsweise um Silikon handeln. Nachfolgend wird die Folie von der Arbeitsfläche wieder entfernt.

Weiterhin kann als Folienmaterial eines der folgenden Materialien gewählt werden: thermoplastische Materialien, Polystyrol, Latex, transparente Gummisorten, Polycarbonat, Acrylat, Teflon, Polyvinyl, Silikonharz, Epoxidharz, PMMA oder Hybridmaterialien aus Silikonharzen, Epoxidharzen bzw. PMMA.

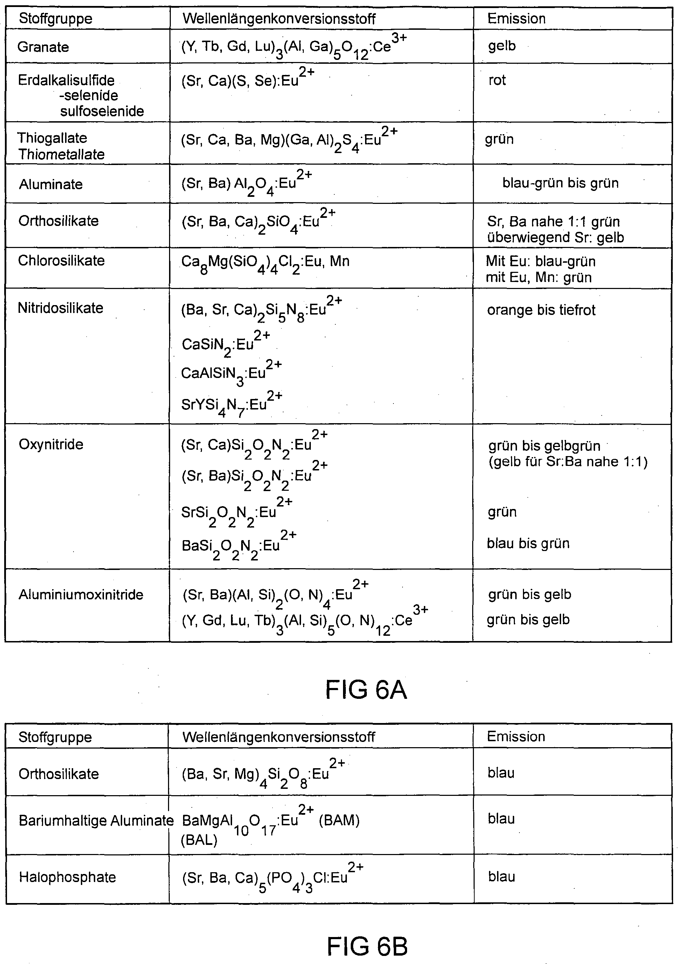

Bei dem Halbleiterchip 18 gemäß Figuren 1C und 1D sind die erste und die zweite wellenlängenkonvertierende Schicht 6, 10 derart angeordnet, dass diese gemeinsame Grenzflächen mit der jeweils benachbarten Schicht ausbilden. Vorliegend wird ein nitridbasierter Halbleiterkörper 1 verwendet, der im Betrieb elektromagnetische Strahlung eines ersten Wellenlängenbereichs aus dem blauen Spektralbereich aussendet. Ein Teil dieser vom Halbleiterkörper 1 emittierten Strahlung wird von dem ersten Wellenlängenkonversionsstoff 7 der ersten wellenlängenkonvertierenden Schicht 6 in Strahlung eines vom ersten Wellenlängenbereich verschiedenen zweiten Wellenlängenbereich, vorliegend aus dem grünen Spektralbereich, umgewandelt. Ein anderer Teil der von dem Halbleiterkörper 1 ausgesandten blauen Strahlung durchläuft die erste wellenlängenkonvertierende Schicht 6 unkonvertiert. Es handelt sich somit bei der ersten wellenlängenkonvertierenden Schicht 6 der Figuren 1B bis 1D nicht um eine gesättigte Beschichtung. Auch bei der zweiten wellenlängenkonvertierenden Schicht 10 handelt es sich vorliegend nicht um eine gesättigte Beschichtung. Ein Teil der vom Halbleiterkörper 1 emittierten Strahlung aus dem blauen Spektralbereich durchläuft auch die zweite wellenlängenkonvertierende Schicht 10 unkonvertiert, während ein anderer Teil der von dem Halbleiterkörper 1 emittierten Strahlung von dem zweiten Wellenlängenkonversionsstoff 11 der zweiten wellenlängenkonvertierenden Schicht 10 in rote Strahlung umgewandelt wird. Wellenlängenkonversionsstoffe, die geeignet sind als erster bzw. zweiter Wellenlängenkonversionsstoff verwendet zu werden, sind der Tabelle der Figur 6A zu entnehmen. Der Halbleiterkörper 1 der Figuren 1C und 1D emittiert mischfarbige Strahlung aus Strahlung des ersten, zweiten und dritten Spektralbereiches, deren Farbort beispielsweise im weißen Bereich der CIE-Normfarbtafel liegt.

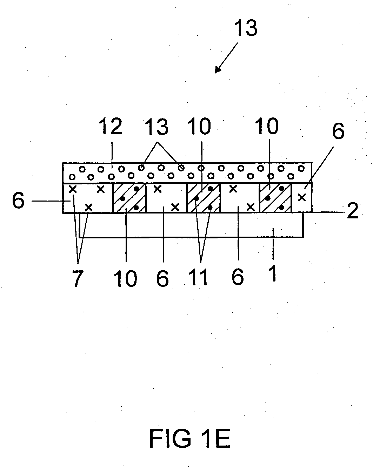

Bei dem Halbleiterchip 18 gemäß dem Ausführungsbeispiel der Figur 1E ist im Unterschied zu dem Halbleiterchip 18 der Figuren 1C und 1D eine dritte wellenlängenkonvertierende Schicht 12 mit einem dritten Wellenlängenkonversionsstoff 13 aufgebracht. Dieser dritte Wellenlängenkonversionsstoff 13 ist dazu geeignet, einen Teil der von dem Halbleiterkörper 1 emittierten Strahlung aus dem ersten Wellenlängenbereich in Strahlung eines vom ersten und zweiten verschiedenen dritten Wellenlängenbereich umzuwandeln. Bei dem Ausführungsbeispiel gemäß der Figur 1E ist die dritte wellenlängenkonvertierende Schicht 12 flächendeckend über der Vorderseite 2 des Halbleiterkörpers 1 in direktem Kontakt mit der ersten und der zweiten wellenlängenkonvertierenden Schicht 6, 10 aufgebracht. Diese dritte wellenlängenkonvertierende Schicht 12 kann beispielsweise mittels Drehschleudern oder Rakeln aufgebracht werden. Weiterhin ist es auch möglich, die dritte wellenlängenkonvertierende Schicht 12 nur in Teilbereichen, also strukturiert, aufzubringen. Hierzu sind beispielsweise die oben in Zusammenhang mit der ersten und der zweiten wellenlängenkonvertierenden Schicht 6, 10 bereits beschriebenen Verfahren geeignet.

Eine solche dritte wellenlängenkonvertierende Schicht 12 ist insbesondere geeignet, in Verbindung mit einem Halbleiterkörper 1 verwendet zu werden, der Strahlung eines ersten Wellenlängenbereiches aussendet, der ultraviolette Strahlung umfasst. Die erste wellenlängenkonvertierende Schicht 6 kann hierbei beispielsweise einen ersten Wellenlängenkonversionsstoff 7 aufweisen, der geeignet ist, einen Teil der Strahlung aus dem ersten Wellenlängenbereich in Strahlung eines zweiten Wellenlängenbereiches aus dem roten Spektralbereich umzuwandeln, und die zweite wellenlängenkonvertierende Schicht 10 kann einen zweiten Wellenlängenkonversionsstoff 11 aufweisen, der geeignet ist, einen Teil der Strahlung des ersten Wellenlängenbereiches in Strahlung eines dritten Wellenlängenbereiches aus dem grünen Spektralbereich umzuwandeln. Die dritte wellenlängenkonvertierende Schicht 12 umfasst bevorzugt einen dritten Wellenlängenkonversionsstoff 13, der geeignet ist, ultraviolette Strahlung des ersten Wellenlängenbereiches in Strahlung eines vierten Wellenlängenbereiches aus dem blauen Spektralbereich umzuwandeln. Der Halbleiterchip 18 emittiert in diesem Fall mischfarbige Strahlung, die Strahlung des roten, des grünen und des blauen Spektralbereiches umfasst. Wellenlängenkonversionsstoffe, die geeignet sind, Strahlung aus dem ultravioletten Spektralbereich in Strahlung aus dem blauen Spektralbereich umzuwandeln und daher vorliegend als dritter Wellenlängenkonversionsstoff verwendet werden können, sind beispielsweise Figur 6B zu entnehmen.

Wird die dritte wellenlängenkonvertierende Schicht 12 beispielsweise in Verbindung mit einem Halbleiterkörper 1 verwendet, der Strahlung eines ersten Wellenlängenbereiches aus dem blauen Spektralbereich aussendet, so ist der dritte Wellenlängenkonversionsstoff 13 der dritten wellenlängenkonvertierenden Schicht 12 bevorzugt geeignet, Strahlung des ersten blauen Wellenlängenbereiches in Strahlung eines vierten Wellenlängenbereiches aus dem blaugrünen Spektralbereich umzuwandeln. Der zweite und der dritte Wellenlängenbereich können hierbei beispielsweise, wie bereits oben beschrieben, ebenfalls so gewählt sein, dass der zweite Wellenlängenbereich aus dem roten Spektralbereich stammt und der dritte Wellenlängenbereich aus dem grünen Spektralbereich. In diesem Fall emittiert der Halbleiterchip 18 mischfarbige Strahlung, die rote, blaue und grüne Strahlung aufweist und deren Farbort bevorzugt im weißen Bereich der CIE-Normfarbtafel liegt.

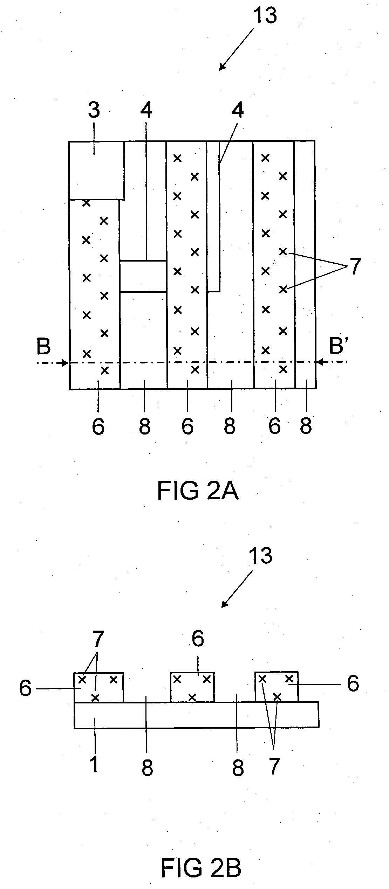

Bei dem Halbleiterchip 18 gemäß den Figuren 2A und 2B ist im Unterschied zu dem Halbleiterchip 18 gemäß den Figuren 1C und 1D nur eine erste wellenlängenkonvertierende Schicht 6 auf ersten streifenförmigen Teilbereichen 5 der strahlungsemittierenden Vorderseite 2 des Halbleiterkörpers 1 aufgebracht und keine zweite wellenlängenkonvertierende Schicht 10 verwendet. Die zweiten Teilbereiche 8 der Vorderseite sind daher vollständig frei von jeglicher Wellenlängenkonversionsschicht. Die erste wellenlängenkonvertierende Schicht 6 dieses Beispiels liegt im Unterschied zu der ersten wellenlängenkonvertierenden Schicht 6 des Beispiels der Figuren 1C und 1D in Form einer gesättigten Beschichtung vor. Das bedeutet, dass Strahlung des Halbleiterkörpers 1, die von den ersten Teilbereichen der Vorderseite ausgesandt wird, vollständig in Strahlung des zweiten Wellenlängenbereiches umgewandelt wird. Vorliegend emittiert der Halbleiterkörper 1 Strahlung eines ersten Wellenlängenbereiches aus dem blauen Spektralbereich und der erste Wellenlängenkonversionsstoff 7 wandelt diese blaue Strahlung des ersten Wellenlängenbereiches in Strahlung aus dem zweiten Wellenlängenbereich, vorliegend aus dem gelben Spektralbereich, um. Als erster Wellenlängenkonversionsstoff ist hierbei beispielsweise YAG:Ce geeignet. Die Anteile an beschichteter zu unbeschichteter Fläche, also von ersten zu zweiten Teilbereichen 5, 8 sind vorliegend so ausgewählt, dass der Halbleiterchip 18 mischfarbige Strahlung mit einem Farbort im weißen Bereich der CIE-Normfarbtafel aussendet.

Eine erste wellenlängenkonvertierene Schicht mit YAG:Ce als erstem Wellenlängenkonversionsstoff liegt beispielsweise in Form einer gesättigten Beschichtung vor, wenn der erste Wellenlängenkonversionsstoff eine Konzentration von ca, 75 Gew% in dem Bindemittel aufweist und die erste wellenlängenkonvertierende Schicht eine Dicke von ca. 50 µm hat. Wird die Dicke und/oder die Konzentration des ersten Wellenlängenkonversionsstoffes verringert, so verliert die erste wellenlängenkonvertierende Schicht die Form einer gesättigten Beschichtung.

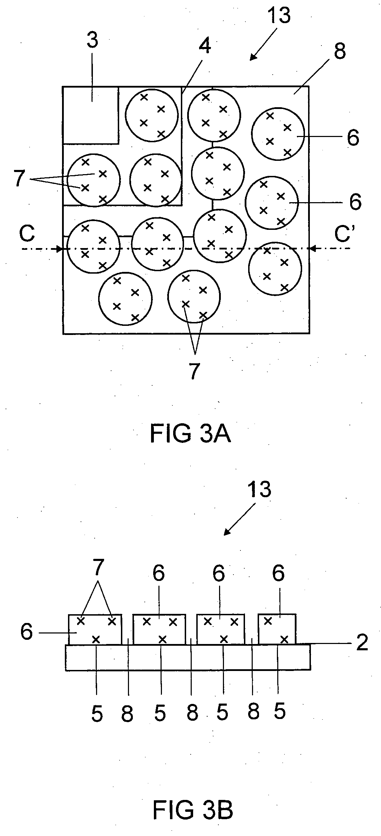

Der Halbleiterchip 18 gemäß den Figuren 3A und 3B weist im Unterschied zu dem Halbleiterchip 18 gemäß der Figuren 2A und 2B eine erste wellenlängenkonvertierende Schicht 6 auf der Vorderseite 2 des strahlungsemittierenden Halbleiterkörpers 1 auf, die auf runden, vorliegend kreisförmigen ersten Teilbereichen 5 aufgebracht ist. Der Halbleiterkörper 1 emittiert wiederum elektromagnetische Strahlung eines ersten Wellenlängenbereichs aus dem blauen Spektralbereich, der von der ersten wellenlängenkonvertierenden Schicht 6 in Strahlung eines zweiten Wellenlängenbereichs aus dem gelben Spektralbereich umgewandelt wird. Hierzu ist beispielsweise der Wellenlängenkonversionsstoff YAG:Ce geeignet. Wie bei dem Beispiel der Figuren 2A und 2B handelt es sich bei der ersten wellenlängenkonvertierenden Schicht 6 um eine gesättigte Beschichtung, d. h. vom Halbleiterkörper in den ersten Teilbereichen 5 ausgesandte Strahlung, wird von der ersten wellenlängenkonvertierenden Schicht 6 vollständig in Strahlung aus dem zweiten Wellenlängenbereich, vorliegend aus dem gelben Spektralbereich, umgewandelt. Der Flächenanteil von beschichteter Vorderseite zu unbeschichteter Vorderseite ist vorliegend beispielsweise derart eingestellt, dass der Halbleiterchip 18 mischfarbige Strahlung aus dem weißen Bereich der CIE-Normfarbtafel aussendet.

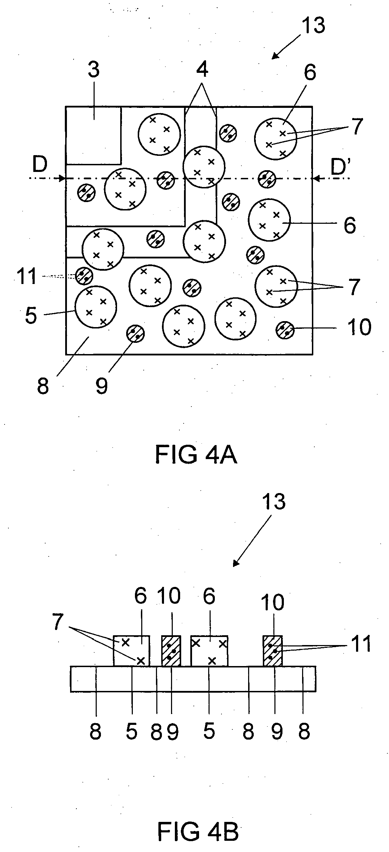

Bei dem Halbleiterkörper gemäß den Figuren 4A und 4B ist im Unterschied zu dem Halbleiterchip 18 gemäß Figur 3A zusätzlich zu der ersten wellenlängenkonvertierenden Schicht 6 in Form einer gesättigten Beschichtung auf den ersten Teilbereichen 5 der strahlungsemittierenden Vorderseite 2 des Halbleiterkörpers 1 eine zweite wellenlängenkonvertierende Schicht 10 ebenfalls in Form einer gesättigten Beschichtung verwendet, die vorliegend auf dritten Teilbereichen 9 der strahlungsemittierenden Vorderseite 2 aufgebracht ist. Die dritten Teilbereiche 9 liegen innerhalb der zweiten Teilbereiche 8, die frei von der ersten wellenlängenkonvertierenden Schicht 6 sind und sind wie die ersten Teilbereiche 5 kreisförmig ausgebildet, weisen jedoch gegenüber den ersten Teilbereichen 5 einen kleineren Radius auf. Auch bei diesem Beispiel emittiert der Halbleiterkörper 1 Strahlung eines ersten Wellenlängenbereiches aus dem blauen Spektralbereich. Blaue Strahlung des ersten Wellenlängenbereiches, die von den ersten Teilbereichen ausgesandt wird, wird von dem ersten Wellenlängenkonversionsstoff 7 der ersten wellenlängenkonvertierenden Schicht 6 vollständig in Strahlung eines zweiten Wellenlängenbereiches aus dem gelben Spektralbereich umgewandelt, während blaue Strahlung des ersten Wellenlängenbereiches, die von den Teilbereichen der Vorderseite des Halbleiterkörpers ausgesandt wird, auf denen die zweite wellenlängenkonvertierenden Schicht aufgebracht ist, vollständig in Strahlung eines dritten Wellenlängenbereiches aus dem grünen Spektralbereich umgewandelt wird. Geeignete Wellenlängenkonversionsstoffe sind beispielsweise der Figur 6A zu entnehmen. Der Halbleiterchip 18 emittiert somit Mischstrahlung, die blaue unkonvertierte Strahlung sowie konvertierte gelbe und grüne Strahlung umfasst. Der Flächenanteil der beschichteten ersten und dritten Teilbereiche 5, 9 zueinander, sowie der unbeschichtete Anteil der strahlungsemittierenden Vorderseite zum beschichteten Anteil bestimmt wiederum den von dem Halbleiterchip 18 ausgesandten Farbort der Strahlung, der vorliegend im weißen Bereich der CIE-Normfarbtafel liegt.

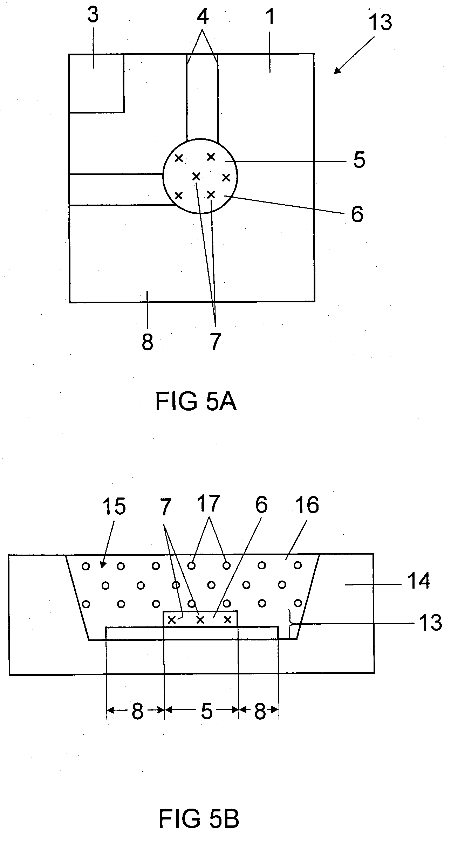

Bei dem Halbleiterkörper gemäß der Figur 5A ist im Unterschied zu den vorhergehenden Ausführungsbeispielen die erste wellenlängenkonvertierende Schicht 6 nur auf einem einzigen ersten Teilbereich 5 der strahlungsemittierenden Vorderseite 2 des Halbleiterkörpers 1 angeordnet. Dieser ist vorliegend kreisförmig ausgebildet. Die erste wellenlängenkonvertierende Schicht 6 liegt in Form einer gesättigten Beschichtung vor, die einen Teil der vom Halbleiterkörper 1 emittierten Strahlung des ersten Wellenlängenbereiches aus dem blauen Spektralbereich in Strahlung eines zweiten Wellenlängenbereiches aus dem roten Spektralbereich umwandelt.

Der Halbleiterkörper gemäß der Figur 5A, ebenso wie die anderen bereits beschriebenen Halbleiterchips 18, kann beispielsweise in einem Bauelement verwendet sein. Bei dem Bauelement gemäß der Figur 5B ist der Halbleiterchip 18 gemäß der Figur 5A in einer Ausnehmung 15 eines Bauelementgehäuses 14 montiert. In die Ausnehmung 15 des Bauelementgehäuses 14 ist eine Vergussmasse 16 gefüllt, die einen vierten Wellenlängenkonversionsstoff 17 umfasst. Der vierte Wellenlängenkonversionsstoff 17 ist vorliegend in ein Matrixmaterial, beispielsweise ein Silikon- oder Epoxidharz eingebettet. Der vierte Wellenlängenkonversionsstoff 17 ist geeignet, von dem Halbleiterchip 18 emittierte blaue Strahlung des ersten Wellenlängenbereiches in Strahlung eines vierten Wellenlängenbereiches, vorliegend aus dem gelben Spektralbereich, umzuwandeln. Die gelbe konvertierte Strahlung wird vorliegend nur zu einem kleinen Teil von dem ersten, rot emittierenden Wellenlängenkonversionsstoff 6 absorbiert, da der relative mit erstem, rotem Wellenlängenkonversionsstoff 6 beschichtete Flächenanteil sehr gering, bevorzugt kleiner 30%, ist.

Die Figuren 6A und 6B zeigen tabellarische Auflistungen exemplarisch ausgewählter Wellenlängenkonversionsstoffe, die beispielsweise in den oben beschriebenen Ausführungsbeispielen verwendet werden können. Die Wellenlängenkonversionsstoffe der Figur 6A sind hierbei sämtlich zumindest durch Strahlung aus dem blauen Spektralbereich anregbar, während die Wellenlängenkonversionsstoffe der Figur 6B zumindest durch Strahlung aus dem ultravioletten Spektralbereich anregbar sind. Chemische Element, die in Klammern angegeben sind, können hierbei in weiten Bereichen gemischt verwendet werden, wobei die Gesamtzahl der Atome gleich dem an der Klammer angegeben Wert sein muss. Ist an der Klammer keine Zahl angegeben, so muss die Gesamtzahl der Atome eins ergeben.

Es sei an dieser Stelle darauf hingewiesen, dass mit dem Ausdruck "ein zweiter Teilbereich ist frei von der ersten wellenlängenkonvertierenden Schicht" gemeint ist, dass zumindest ein wesentlicher zweiter Teilbereich der Vorderseite nicht mit dieser Schicht bedeckt ist. Dadurch wird ein wesentlicher Anteil der von dem Halbleiterkörper in diesem Teilbereich emittierten Strahlung nicht durch die erste wellenlängenkonvertierende Schicht umgewandelt und steht zur Verfügung entweder mit der bereits konvertierten Strahlung gemischt zu werden, so dass mischfarbige Strahlung entsteht oder durch einen weiteren Wellenlängenkonversionsstoff ihrerseits zumindest teilweise konvertiert zu werden, so dass ebenfalls mischfarbige Strahlung entsteht. Insbesondere ist mit dem Ausdruck "ein zweiter Teilbereich ist frei von der ersten wellenlängenkonvertierenden Schicht" keine Teilbereiche gemeint, die beispielsweise bei der Produktion als Nebeneffekt entstehen und nicht weiter zur Funktion des Halbleiterchips beitragen.

## Patentansprüche

1. Optoelektronischer Halbleiterchip (18) mit:
- einem Halbleiterkörper (1), der eine Halbleiterschichtenfolge umfasst, die geeignet ist, elektromagnetische Strahlung eines ersten Wellenlängenbereiches von seiner Vorderseite (2) zu emittieren,
- einer ersten wellenlängenkonvertierenden Schicht (6) auf zumindest einem ersten Teilbereich (5) der Vorderseite (2) des Halbleiterkörpers (1) mit einem ersten Wellenlängenkonversionsstoff (7), der Strahlung des ersten Wellenlängenbereiches in Strahlung eines vom ersten Wellenlängenbereich verschiedenen, zweiten Wellenlängenbereich umwandelt, wobei mindestens ein zweiter Teilbereich (8) der Vorderseite (2) frei von der ersten wellenlängenkonvertierenden Schicht (6) ist und die erste wellenlängenkonvertierende Schicht (6) als Folie ausgebildet ist, in der der erste Wellenlängenkonversionsstoff (7) enthalten ist,
- auf dem zweiten oder zumindest einem vom ersten Teilbereich (5) verschiedenen dritten Teilbereich (9) der Vorderseite (2) eine zweite wellenlängenkonvertierende Schicht (10) mit einem zweiten Wellenlängenkonversionsstoff (11) aufgebracht ist, der Strahlung des ersten Wellenlängenbereiches in Strahlung eines vom ersten und zweiten Wellenlängenbereich verschiedenen dritten Wellenlängenbereich umwandelt, und
- direkt auf der ersten und zweiten wellenlängenkonvertierenden Schicht (6, 10) eine dritte wellenlängenkonvertierende Schicht (12) mit einem dritten Wellenlängenkonversionsstoff (13) aufgebracht ist, der Strahlung des ersten Wellenlängenbereiches in Strahlung eines vom ersten, zweiten und dritten Wellenlängenbereich verschiedenen vierten Wellenlängenbereich umwandelt.

2. Optoelektronischer Halbleiterchip (18) nach Anspruch 1, bei dem die erste wellenlängenkonvertierende Schicht (6) Strahlung aus dem ersten Wellenlängenbereich, die von dem ersten Teilbereich emittiert wird, vollständig in Strahlung des zweiten Wellenlängenbereiches umgewandelt wird.

3. Optoelektronischer Halbleiterchip (18) nach Anspruch 1 oder 2, bei dem die zweite wellenlängenkonvertierende Schicht (10) Strahlung aus dem ersten Wellenlängenbereich, der von der Vorderseite des Halbleiterkörpers in dem Teilbereich emittiert wird, auf den die zweite wellenlängenkonvertierende (10) Schicht aufgebracht ist, vollständig in Strahlung des dritten Wellenlängenbereiches umgewandelt wird.

4. Optoelektronischer Halbleiterchip (18) nach einem der obigen Ansprüche, bei dem die zweite wellenlängenkonvertierende (10) Schicht als Folie ausgebildet ist oder eine Folie umfasst, in der der zweite Wellenlängenkonversionsstoff (11) enthalten ist.

5. Optoelektronischer Halbleiterchip (18) nach einem der obigen Ansprüche, bei dem die dritte wellenlängenkonvertierende Schicht (12) als Folie ausgebildet ist oder eine Folie umfasst, in der der dritte Wellenlängenkonversionsstoff (13) enthalten ist.

6. Optoelektronischer Halbleiterchip (18) nach einem der Ansprüche 1 bis 5, bei dem die Folie bzw. mindestens eine der Folien auf die Vorderseite (2) aufgeklebt ist.

7. Optoelektronischer Halbleiterchip (18) nach einem der obigen Ansprüche, bei dem der erste Teilbereich (5) streifenförmig oder rund ausgebildet ist und/oder der dritte Teilbereich (9) streifenförmig oder rund ausgebildet ist.

8. Optoelektronisches Halbleiterbauelement mit einem Halbleiterchip (18) nach einem der obigen Ansprüche, dem in dessen vorgesehener Abstrahlrichtung ein Vergussmaterial (16) mit einem vierten Wellenlängenkonversionsstoff (17) nachgeordnet ist, der Strahlung des ersten Wellenlängenbereiches in Strahlung eines vom ersten, zweiten, dritten und vierten Wellenlängenbereich verschiedenen fünften Wellenlängenbereich umwandelt.

9. Verfahren zur Herstellung eines optoelektronischen Halbleiterchips (18) mit den Schritten:
- Bereitstellen eines Halbleiterkörpers (1) mit einer Halbleiterschichtenfolge, die geeignet ist, elektromagnetische Strahlung eines ersten Wellenlängenbereiches zu emittieren, und
- Aufbringen einer ersten wellenlängenkonvertierenden Schicht (6) auf zumindest einem ersten Teilbereich (5) der Vorderseite (2) des Halbleiterkörpers (1), die einen ersten Wellenlängenkonversionsstoff (7) umfasst, der Strahlung des ersten Wellenlängenbereiches in Strahlung eines vom ersten verschiedenen zweiten Wellenlängenbereiches umwandelt, wobei mindestens ein zweiter Teilbereich (8) der Vorderseite (2) frei von der ersten wellenlängenkonvertierenden Schicht (6) bleibt,
wobei die erste wellenlängenkonvertierende Schicht (6) als Folie aufgebracht wird, in der der erste Wellenlängenkonversionsstoff (7) enthalten ist,
- wobei auf dem zweiten oder zumindest einem vom ersten Teilbereich (5) verschiedenen dritten Teilbereich (9) der Vorderseite (2) eine zweite wellenlängenkonvertierende Schicht (10) mit einem zweiten Wellenlängenkonversionsstoff (11) aufgebracht wird, der Strahlung des ersten Wellenlängenbereiches in Strahlung eines vom ersten und zweiten Wellenlängenbereich verschiedenen dritten Wellenlängenbereich umwandelt, und
- direkt auf der ersten und zweiten wellenlängenkonvertierenden Schicht (6, 10) eine dritte wellenlängenkonvertierende Schicht (12) mit einem dritten Wellenlängenkonversionsstoff (13) aufgebracht wird, der Strahlung des ersten Wellenlängenbereiches in Strahlung eines vom ersten, zweiten und dritten Wellenlängenbereich verschiedenen vierten Wellenlängenbereich umwandelt.

10. Verfahren nach Anspruch 9, bei dem die erste und/oder gegebenenfalls die zweite und/oder gegebenenfalls die dritte wellenlängenkonvertierende Schicht (6, 10, 13) mittels eines Druckverfahrens und/oder mittels eines lithographischen Verfahrens aufgebracht wird und/oder mittels eines elektrophoretischen Verfahrens aufgebracht wird.

11. Verfahren nach einem der Ansprüche 9 bis 10, bei dem die zweite und/oder die dritte wellenlängenkonvertierende Schicht (6, 10, 13) als Folie aufgebracht wird.

## Claims

1. Optoelectronic semiconductor chip (18) comprising:
- a semiconductor body (1) comprising a semiconductor layer sequence suitable for emitting electromagnetic radiation in a first wavelength range from its front side (2),
- a first wavelength-converting layer (6) on at least one first partial region (5) of the front side (2) of the semiconductor body (1) with a first wavelength conversion substance (7), which converts radiation in the first wavelength range into radiation in a second wavelength range, which is different from the first wavelength range, wherein at least one second partial region (8) of the front side (2) is free of the first wavelength-converting layer (6) and the first wavelength-converting layer (6) is embodied as a film containing the first wavelength conversion substance (7),
- a second wavelength-converting layer (10) with a second wavelength conversion substance (11) is applied on the second or at least one third partial region (9) - different from the first partial region (5) - of the front side (2), which second wavelength conversion substance converts radiation in the first wavelength range into radiation in a third wavelength range, which is different from the first and second wavelength ranges, and
- a third wavelength-converting layer (12) with a third wavelength conversion substance (13) is applied directly on the first and second wavelength-converting layers (6, 10), which third wavelength conversion substance converts radiation in the first wavelength range into radiation in a fourth wavelength range, which is different from the first, second and third wavelength ranges.

2. Optoelectronic semiconductor chip (18) according to Claim 1, wherein the first wavelength-converting layer (6) converts radiation from the first wavelength range that is emitted by the first partial region completely into radiation in the second wavelength range.

3. Optoelectronic semiconductor chip (18) according to Claim 1 or 2, wherein the second wavelength-converting layer (10) converts radiation from the first wavelength range that is emitted from the front side of the semiconductor body in the partial region to which the second wavelength-converting layer (10) is applied completely into radiation in the third wavelength range.

4. Optoelectronic semiconductor chip (18) according to any of the preceding claims, wherein the second wavelength-converting layer (10) is embodied as a film or comprises a film which contains the second wavelength conversion substance (11).

5. Optoelectronic semiconductor chip (18) according to any of the preceding claims, wherein the third wavelength-converting layer (12) is embodied as a film or comprises a film which contains the third wavelength conversion substance (13).

6. Optoelectronic semiconductor chip (18) according to any of Claims 1 to 5, wherein the film or at least one of the films is adhesively bonded onto the front side (2).

7. Optoelectronic semiconductor chip (18) according to any of the preceding claims, wherein the first partial region (5) is embodied in a strip-shaped or round fashion and/or the third partial region (9) is embodied in a strip-shaped or round fashion.

8. Optoelectronic semiconductor component comprising a semiconductor chip (18) according to any of the preceding claims, downstream of which, in the envisaged emission direction thereof, there is disposed a potting material (16) comprising a fourth wavelength conversion substance (17), which converts radiation in the first wavelength range into radiation in a fifth wavelength range, which is different from the first, second, third and fourth wavelength ranges.

9. Method for producing an optoelectronic semiconductor chip (18) comprising the following steps:
- providing a semiconductor body (1) comprising a semiconductor layer sequence suitable for emitting electromagnetic radiation in a first wavelength range, and
- applying a first wavelength-converting layer (6) on at least one first partial region (5) of the front side (2) of the semiconductor body (1), said first wavelength-converting layer comprising a first wavelength conversion substance (7), which converts radiation in the first wavelength range into radiation in a second wavelength range, which is different from the first wavelength range, wherein at least one second partial region (8) of the front side (2) remains free of the first wavelength-converting layer (6),
wherein the first wavelength-converting layer (6) is applied as a film containing the first wavelength conversion substance (7),
- wherein a second wavelength-converting layer (10) with a second wavelength conversion substance (11) is applied on the second or at least one third partial region (9) - different from the first partial region (5) - of the front side (2), which second wavelength conversion substance converts radiation in the first wavelength range into radiation in a third wavelength range, which is different from the first and second wavelength ranges, and
- a third wavelength-converting layer (12) with a third wavelength conversion substance (13) is applied directly on the first and second wavelength-converting layers (6, 10), which third wavelength conversion substance converts radiation in the first wavelength range into radiation in a fourth wavelength range, which is different from the first, second and third wavelength ranges.

10. Method according to Claim 9, wherein the first and/or if appropriate the second and/or if appropriate the third wavelength-converting layer (6, 10, 13) are/is applied by means of a printing method and/or by means of a lithographic method and/or are/is applied by means of an electrophoretic method.

11. Method according to either of Claims 9 and 10, wherein the second and/or the third wavelength-converting layer (6, 10, 13) are/is applied as a film.

## Revendications

1. Puce de semi-conducteur optoélectronique (18) avec :
- un corps semi-conducteur (1) qui comprend une suite de couches semi-conductrices, laquelle est capable d'émettre un rayonnement électromagnétique d'une première plage de longueurs d'onde depuis sa face avant (2) ;
- une première couche de conversion de longueur d'onde (6) qui se trouve sur tout au moins une première zone partielle (5) de la face avant (2) du corps semi-conducteur (1) et qui est pourvue d'une première substance de conversion de longueur d'onde (7), laquelle convertit le rayonnement de la première plage de longueurs d'onde en un rayonnement dans une deuxième plage de longueurs d'onde qui est différente de la première plage de longueurs d'onde, où au moins une deuxième zone partielle (8) de la face avant (2) est dépourvue de la première couche de conversion de longueur d'onde (6) et où la première couche de conversion de longueur d'onde (6) est conçue sous la forme d'un film, dans lequel est contenue la première substance de conversion de longueur d'onde (7) ;
- une deuxième couche de conversion de longueur d'onde (10) est appliquée avec une deuxième substance de conversion de longueur d'onde (11), sur la deuxième ou, tout au moins, sur une troisième zone partielle (9) de la face avant (2), laquelle troisième zone partielle est différente de la première zone partielle (5), laquelle deuxième substance de conversion de longueur d'onde (11) convertit le rayonnement de la première plage de longueurs d'onde en un rayonnement d'une troisième plage de longueurs d'onde, laquelle est différente de la première et de la deuxième plage de longueurs d'onde ; et
- une troisième couche de conversion de longueur d'onde (12) est appliquée directement sur la première et sur la deuxième couche de conversion de longueur d'onde (6, 10), avec une troisième substance de conversion de longueur d'onde (13), laquelle convertit le rayonnement de la première plage de longueurs d'onde en un rayonnement d'une quatrième plage de longueurs d'onde, laquelle est différente de la première, de la deuxième et de la troisième plage de longueurs d'onde.

2. Puce de semi-conducteur optoélectronique (18) selon la revendication 1, selon laquelle la première couche de conversion de longueur d'onde (6) permet de convertir entièrement un rayonnement de la première plage de longueurs d'onde, qui est émise par la première zone partielle, en un rayonnement de la deuxième plage de longueurs d'onde.

3. Puce de semi-conducteur optoélectronique (18) selon la revendication 1 ou 2, selon laquelle la couche deuxième de conversion de longueur d'onde (10) permet de convertir entièrement un rayonnement de la première plage de longueurs d'onde, qui est émise par la face avant du corps semi-conducteur dans la zone partielle, sur laquelle est appliquée la deuxième couche de conversion de longueur d'onde (10), en un rayonnement de la troisième plage de longueurs d'onde.

4. Puce de semi-conducteur optoélectronique (18) selon l'une des revendications susmentionnées, selon laquelle la deuxième couche de conversion de longueur d'onde (10) est conçue sous la forme d'un film ou comprend un film, dans lequel est contenue la deuxième substance de conversion de longueur d'onde (11).

5. Puce de semi-conducteur optoélectronique (18) selon l'une des revendications susmentionnées, selon laquelle la troisième couche de conversion de longueur d'onde (12) est conçue sous la forme d'un film ou comprend un film, dans lequel est contenue la troisième substance de conversion de longueur d'onde (13).

6. Puce de semi-conducteur optoélectronique (18) selon l'une des revendications 1 à 5, selon laquelle le film respectivement au moins l'un des films est collé sur la face avant (2).

7. Puce de semi-conducteur optoélectronique (18) selon l'une des revendications susmentionnées, selon laquelle la première zone partielle (5) est conçue en forme de bande ou de manière circulaire et/ou la troisième zone partielle (9) est conçue en forme de bande ou de manière circulaire.

8. Dispositif à semi-conducteurs optoélectronique avec une puce de semi-conducteur (18) selon l'une des revendications susmentionnées, en aval de laquelle une matière d'enrobage (16) pourvue d'une quatrième substance de conversion de longueur d'onde (17) est mise en place dans sa direction de rayonnement prévue, laquelle quatrième substance de conversion de longueur d'onde convertit le rayonnement de la première plage de longueurs d'onde en un rayonnement d'une cinquième plage de longueurs d'onde, laquelle est différente de la première, de la deuxième, de la troisième et de la quatrième plage de longueurs d'onde.

9. Procédé destiné à la fabrication d'une puce de semi-conducteurs optoélectronique (18), comprenant les phases suivantes :
- la préparation d'un corps semi-conducteur (1) qui comprend une suite de couches semi-conductrices, laquelle est capable d'émettre un rayonnement électromagnétique d'une première plage de longueurs d'onde ; et
- l'application d'une première couche de conversion de longueur d'onde (6) sur tout au moins une première zone partielle (5) de la face avant (2) du corps semi-conducteur (1), laquelle comprend une première substance de conversion de longueur d'onde (7) qui convertit le rayonnement de la première plage de longueurs d'onde en un rayonnement d'une deuxième plage de longueurs d'onde qui est différente de la première plage de longueurs d'onde, où au moins une deuxième zone partielle (8) de la face avant (2) reste dépourvue de la première couche de conversion de longueur d'onde (6), où la première couche de conversion de longueur d'onde (6) est appliquée sous la forme d'un film, dans lequel est contenue la première substance de conversion de longueur d'onde (7) ;
- selon lequel une deuxième couche de conversion de longueur d'onde (10) est appliquée avec une deuxième substance de conversion de longueur d'onde (11) sur la deuxième ou, tout au moins, sur une troisième zone partielle (9) de la face avant (2), laquelle est différente de la première zone partielle (5), laquelle deuxième substance de conversion de longueur d'onde convertit le rayonnement de la première plage de longueurs d'onde en un rayonnement d'une troisième plage de longueurs d'onde, laquelle est différente de la première et de la deuxième plage de longueurs d'onde ; et
- une troisième couche de conversion de longueur d'onde (12) est appliquée directement sur la première et sur la deuxième couche de conversion de longueur d'onde couche (6, 10), avec une troisième substance de conversion de longueur d'onde (13), laquelle convertit le rayonnement de la première plage de longueurs d'onde en un rayonnement d'une quatrième plage de longueurs d'onde, laquelle est différente de la première, de la deuxième et de la troisième plage de longueurs d'onde.

10. Procédé selon la revendication 9, selon lequel la première et/ou, le cas échéant, la deuxième et/ou, le cas échéant, la troisième couche de conversion de longueur d'onde (6, 10, 13) sont appliquées au moyen d'un procédé d'impression et/ou au moyen d'un procédé lithographique et/ou au moyen d'un procédé électrophorétique.

11. Procédé selon l'une des revendications 9 à 10, selon lequel la deuxième et/ou la troisième couche de conversion de longueur d'onde (6, 10, 13) est appliquée sous la forme d'un film.
